# EUROPEAN PATENT APPLICATION

(11) **EP 3 744 525 A1**
(43) Date of publication of application: **02.12.2020**
(21) Application number: 19176858.9
(22) Date of filing: 28.05.2019
(51) Int. Cl.: B41J 2/14

(54) **LIQUID EJECTION DEVICE WITH DAMPENING DEVICE**

(71) Applicant: Canon Production Printing Holding B.V., 5914 HH Venlo (NL)
(72) Inventor: REINTEN, Hans, 5914 HH Venlo (NL); DERKS, Roy J.S., 5914 HH Venlo (NL); HOLLANDS, Peter J., 5914 HH Venlo (NL)
(74) Representative: Canon Production Printing IP Department

(57) **Abstract**

A liquid ejection device comprising:
- a liquid duct system (14) having a plurality of nozzles (10), a plurality of pressure chambers (12) communicating with the nozzles (10), and a liquid supply line (24) communicating with the pressure chambers (12),
- a plurality of actuators (22) arranged to pressurize the liquid in the pressure chambers (12) for ejecting droplets of liquid through the nozzles (10), and
- a dampening device (26) comprising a cavity (28) that is in fluid communication with the duct system (14) and is delimited by a resilient foil (30) for dampening pressure waves in the liquid,
- characterized in that the resilient foil (30) is pre-formed in a corrugated shape.

## Description

The invention relates to a liquid ejection device comprising:
- a liquid duct system having a plurality of nozzles, a plurality of pressure chambers communicating with the nozzles, and a liquid supply line communicating with the pressure chambers,
- a plurality of actuators arranged to pressurize the liquid in the pressure chambers for ejecting droplets of liquid through the nozzles, and
- a dampening device comprising a cavity that is in fluid communication with the duct system and is delimited by a resilient foil for dampening pressure waves in the liquid.

More particularly, the invention relates to a liquid ejection device in the form of an ink jet print head.

In an ink jet printer, the actuators are activated at suitable timings so that ink droplets are ejected onto the print substrate. The nozzles are arranged in at least one line with only small spacings between the individual nozzles, so that a high print resolution can be achieved. In order to achieve a compact design and a high resolution, the print head may be formed as a MEMS device (Micro-Electro-Mechanic System) in a photolithographic etching process. One or more dampening devices are provided for controlling the inertance of the liquid and reducing cross-talk between the individual nozzles.

In a known inkjet print head, the dampening device is formed by a cavity covered by a flexible membrane that separates a gas volume from the liquid.

It is an object of the invention to provide a liquid ejection device with a compact and efficient dampening device.

According to the invention, in order to achieve this object, the resilient foil is pre-formed in a corrugated shape.

When the pre-formed resilient foil is not subject to an external force or pressure, it assumes its corrugated shape. When a differential pressure develops across the foil, the foil is subject to tension forces which tend to smoothen-out the corrugations, so that the strain occurring in the foil is predominantly a bending strain to which the foil can yield relatively easily, so that the foil has a high compliance. Only when the foil has been deflected to such an extent that the corrugations are almost eliminated, the strain in the foil will turn into a predominantly in-plane strain and the compliance will decrease.

In contrast, if the foil were flat in the natural state, the in-plane strain would limit the compliance of the foil form the outset. Thus, by pre-forming the foil in the corrugated shape, the compliance can be increased significantly, so that a relatively small surface area of the foil and, accordingly, small dimensions of the cavity are sufficient for providing a high absorption capacity for pressure surges in the liquid.

Advantageously, the corrugated foil is configured for damping both high and low frequency pressure oscillations. The relatively higher frequency oscillations in a print head are generally the result of cross talk between different actuators, while lower frequency oscillations may be caused by variations in e.g. the flow or pressure of the liquid supplied to the cavity.

More specific optional features of the invention are indicated in the dependent claims.

The corrugations in the foil may be confined to a central area of the foil that is surrounded by a margin where the foil is flat, so that the cavity of the dampening device may be tightly sealed by the flat marginal area of the foil.

The foil may for example be press-formed or may be made of a thermoplastic resin which can be pre-formed in a heated state and will then retain the corrugated shape after it has cooled down.

In an embodiment, the foil is attached to a frame, such that the foil separates the cavity from an air volume inside of the frame. The frame is preferably formed in a process separate from the formation of the liquid ejection device, which device is preferably formed by MEMS photolithographic etching. The frame is configured and dimensioned to fit the substrate forming the cavity. The air volume allows for substantially unimpeded or low resistance deformation and/or movement of the foil.

In an embodiment, the foil is configured, such that corrugations in the foil at least partially smoothen out under the influence of a pressure surge in the cavity as a result of one or more actuators pressurizing the liquid in the pressure chambers, thereby increasing a volume of the cavity. The compliance, elasticity, and/or resilience of the foil is selected to lie in a predetermined range, wherein the corrugated foil is deformable under influence of the pressure variations in the cavity. The desired deformation properties of the foil may be achieved by one hand the material properties of the foil and on the other the shape and/or pattern of the corrugations.

In an embodiment, a compliance of the corrugated foil is substantially linear for a predetermined range of a volume of cavity, at least compared to a flat foil of the same dimensions and material. Cross talk dampeners formed by a flat foil show a strong nonlinear behavior in their compliance as a function of the volume variation of the cavity. Generally, the compliance of flat foils peaks at the resting volume of the cavity (when no external pressure is applied). In contrast, a corrugated foil displays a more linear, specifically a more constant, compliance as the volume of the cavity increases and/or decreases, at least around the resting volume. Specifically, the compliance peak is substantially absent or much reduced in a corrugated foil as compared to a similar flat foil. Such a linear relationship improves the effectiveness of the foil over a wider volume range. It also provides an improved measure for accurately determining and/or tuning the properties of the liquid ejection device. In a preferred example, the compliance of the corrugated foil is substantially constant with respect to and/or invariant to changes in the volume of the cavity, specifically in a range centered around a rest position of the foil. The rest position corresponds e.g. to the state of the foil wherein the liquid ejection device, specifically the actuators, are inactive.

In an embodiment, the liquid ejection device is a MEMS device formed in a photolithographic etching process. The MEMS device is formed of stacked substrates, each etched in a (photo)lithographic process. In a preferred example, one substrate was etched such that it comprises cavity. This substrate is attached to a further layer formed of a substrate, which was (photo)lithographically etched, such that the pressure chamber and the nozzle are formed in said layer. The thickness, as measured perpendicular to the plane of said substrate and/or layer, of the substrate comprising the cavity is greater, specifically at least twice greater, than the thickness of the layer with the pressure chamber and the nozzle. Preferably, said layer is formed of two substrates, wherein a first substrate is etched to comprise the pressure chamber and a second substrate is etched to comprise the nozzle. The pressure chamber substrate is stacked on the nozzle substrate, wherein the cavity substrate is stacked on the pressure chamber substrate. A diaphragm is preferably provided between the pressure chamber substrate and the cavity substrate, such that one side of the pressure chamber is formed by at least part of said diaphragm. In an embodiment, an actuator cavity is provided in the cavity substrate, in which actuator cavity the actuator is disposed. The actuator cavity is preferably positioned on an opposite side of the diaphragm with respect to the pressure chamber. In another embodiment, the substrates, specifically the nozzle substrate, the pressure chamber substrate, and the cavity substrate are formed of silicon. Such a liquid ejection device structure allows for a space and production efficient design.

An embodiment example will now be described in conjunction with the drawings, wherein:
- Fig. 1: is a cross-sectional view of a part of a liquid ejection device;
- Fig. 2: is an enlarged cross-sectional view of a dampening device;
- Fig. 3: is an enlarged top view of a dampening device;
- Fig. 4: show a different state of the dampening device;
- Fig. 5: is a view of the dampening device as seen in the direction of arrows IV-IV in Fig. 2; and
- Fig. 6: is a compliance diagram of the dampening device.

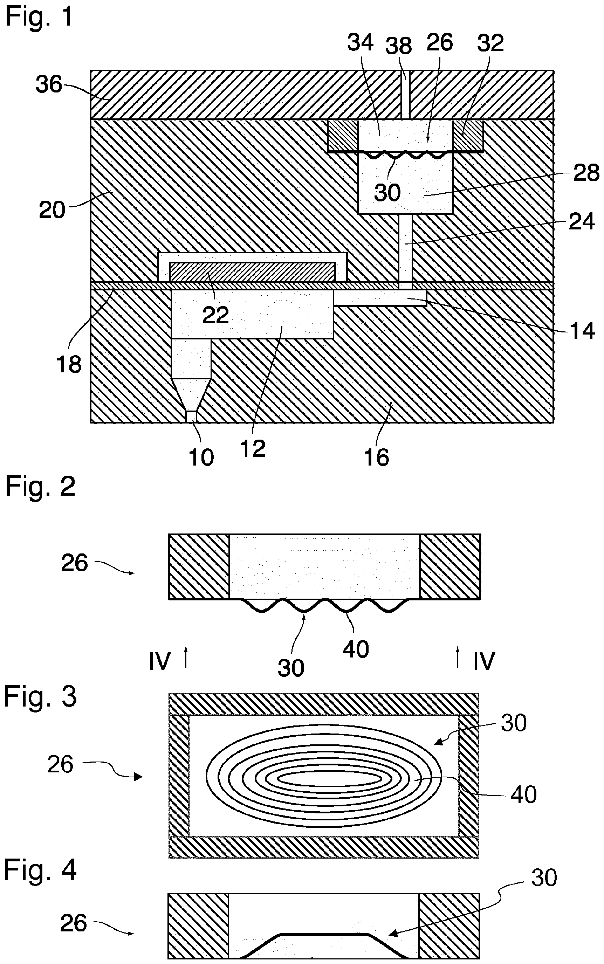

In the example shown in Fig. 1, an ejection unit of a liquid ejection device, e.g. an ink jet print head, comprises a nozzle 10 and a pressure chamber 12 that communicates with the nozzle. The print head has a large number of such ejection units that are aligned with narrow spacings in the direction normal to the plane of the drawing in Fig. 1 and are interconnected by a duct system 14. The nozzle 10 and the pressure chamber 12 are each formed in a respective monolithic substrate that may be made of silicon, for example, and is covered by a diaphragm 18. The diaphragm 18 separates liquid ejection device in a top and bottom part. Together the nozzle 10 forming and pressure chamber 12 forming substrates form the bottom layer 16 of the liquid ejection device. The top layer is formed by the substrate 20. Preferably, the pressure chamber 12 is formed in silicon substrate or wafer which is attached to a further silicon wafer wherein the nozzles 10 are formed. A part of the duct system 14 is formed in another silicon substrate 20 that is bonded to the diaphragm 18. A bending-type piezoelectric actuator 22 is disposed in an actuator cavity of the substrate 20 and on a part of the diaphragm 18 that covers the pressure chamber 12. The actuator 22 has electrodes (not shown here) connected to an electronic control system, and when a voltage is applied to the electrodes, the actuator bends and deflects the diaphragm 18 into the pressure chamber 12, so that a pressure wave is generated in the liquid contained therein. As a consequence, a droplet is expelled from the nozzle 10.

The part of the duct system 14 formed in the substrate 20 forms a liquid supply line 24 that is connected to the pressure chamber 12 via passages formed in the substrates 16, 20 and via a through-hole in the diaphragm 18. The liquid supply line 24 connects the pressure chambers 12 of the plurality of ejection units. Since the distance between adjacent ejection units is relatively small, a pressure wave generated in one pressure chamber 12 may propagate through the ink supply line 24 into neighboring pressure chambers, resulting in a certain amount of undesired cross-talk among the various nozzles. Moreover, when a large number of adjacent nozzles are firing at a high rate, the ink must flow through the liquid supply line 24 with a relatively high flow velocity in order to replace the ink that is being consumed. Then, when a larger number of the nozzles suddenly stop firing, the inertance of the ink will cause a pressure surge that may affect the jetting behavior of the ejection units, so that artefacts are created in the printed image.

In order to reduce these pressure surges and the cross-talk, a number of dampening devices 26 are arranged in the ink supply line 24. In the example shown, the dampening device 26 has a cavity 28 that is formed by a part of the ink supply line 24 and is delimited by a resilient foil 30. The cavity 28 is formed as a trench 29, which extends over the width of the row of nozzles 10. The foil 30 is attached to a frame 32 and separates the cavity 28 from an air volume 34 inside of the frame 32. The air volume 34 is delimited by a cover plate 36 that covers the substrate 20 and the frame 32 but has a through-bore 38 through which the air volume 34 communicates with the ambient air (or alternatively with a vacuum system that maintains a certain underpressure in the entire duct system 14).

As can be seen more clearly in Fig. 2, the foil 30, which may be a polyimide foil, for example, has been pre-formed into a corrugated shape with corrugations 40 that extend in the direction normal to the plane of the drawing in Fig. 2 and have an approximately sinusoidal profile. Thanks to the corrugations 40, the foil 30 has a high compliance, so that pressure surges in the ink supply line 24 can be absorbed effectively even though the surface area of the cavity 28 that is covered by the foil 30 is relatively small.

Fig. 3 is a top view showing that the foil 30 has been pre-formed such that the corrugations 40 comprise elliptical or circular forms. When viewed perpendicular to the plane of the foil 30 one or more corrugations 40 each form an endless loop or ring. This allows the foil 30 to act as a bellow against pressure surges. The loop shaped corrugations may be easily formed e.g. by thermoforming or injection molding and provide rigidity to the foil 30, making it easier to handle during assembly.

Fig. 4 illustrates a situation where a pressure surge in the ink supply system 24 has caused the foil 30 to deflect upwards, so that it is put under tension and the corrugations 40 have been smoothened out. In this state, the compliance of the foil will become smaller, but the volume of the cavity 28 has already been increased by a significant amount at that instant, so that a major part of the pressure surge has already been absorbed.

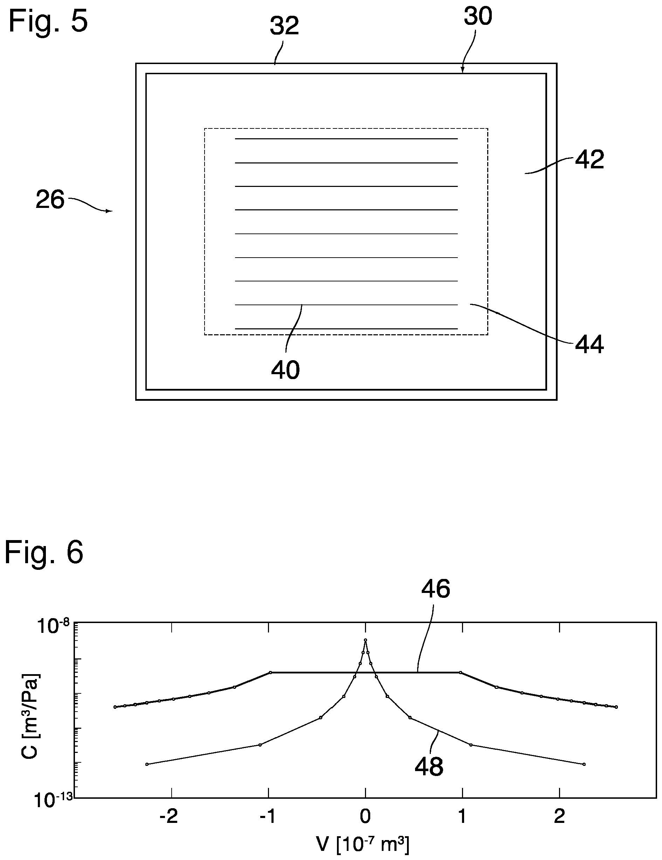

Fig. 5 shows the dampening device 26 in a view as seen in the direction of arrows IV-IV in Fig. 2. The frame 32 has a rectangular shape and the foil 30 has been tightly attached to the frame 32 in the area of a margin 42. The corrugations 40 are confined to a central area 44 of the foil 30 inside of the frame 32, whereas the margin 42 of the foil is flat. The corrugations 40 may be formed in this pattern for example by press-forming in a mold, possibly in the state where the foil is at an elevated temperature.

It will be understood that the size of the corrugations 40 has been exaggerated in the drawing and that, in practice, the "wavelength" of the corrugations may be significantly smaller.

Fig. 6 is a compliance diagram where the compliance C of the foil 30 has been shown (on a logarithmic scale) as a function of the volume change V of the cavity 28. The compliance of the foil 30 is given by a curve 46. For comparison, a curve 48 shows the compliance of a flat foil with the same thickness, size, shape and material composition as the foil 30. It can be seen that the compliance of the corrugated foil 30 has a high and essentially constant level as long as the volume variations of the cavity 28 (as caused by a pressure difference across the foil) are not too large. In contrast, the compliance of the flat foil as given by the curve 48 has a pronounced non-linearity and forms a sharp peak at V = 0 (no differential pressure). This shows that the corrugations 40 lead to a gain in compliance and a suppression of the non-linearity of the compliance as a function of actual pressure.

## Claims

1. A liquid ejection device comprising:
- a liquid duct system (14) having a plurality of nozzles (10), a plurality of pressure chambers (12) communicating with the nozzles (10), and a liquid supply line (24) communicating with the pressure chambers (12),
- a plurality of actuators (22) arranged to pressurize the liquid in the pressure chambers (12) for ejecting droplets of liquid through the nozzles (10), and
- a dampening device (26) comprising a cavity (28) that is in fluid communication with the duct system (14) and is delimited by a resilient foil (30) for dampening pressure waves in the liquid,
- **characterized in that** the resilient foil (30) is pre-formed in a corrugated shape.

2. The liquid ejection device according to claim 1, wherein corrugations (40) of the foil (30) have a sinusoidal profile.

3. The liquid ejection device according to claim 1 or 2, wherein the corrugations (40) of the foil (30) are confined to a central area (44) of the foil surrounded by a flat margin (42).

4. The liquid ejection device according to any of the previous claims, wherein the corrugations (40) form endless loops (40) when viewed in a direction perpendicular to a plane of the foil (30).

5. The liquid ejection device according to any of the previous claims, wherein the foil (30) is attached to a frame (32), such that the foil (30) separates the cavity (28) from an air volume (34) inside of the frame (32).

6. The liquid ejection device according to any of the previous claims, wherein the foil (30) is configured, such that corrugations (40) in the foil (30) at least partially smoothen out under the influence of a pressure surge in the cavity (24) as a result of one or more actuators (22) pressurizing the liquid in the pressure chambers (12), thereby increasing a volume of the cavity (28).

7. The liquid ejection device according to any of the previous claims, wherein a compliance (46) of the foil (30) is substantially linear for a predetermined range of a volume of cavity (28).

8. The liquid ejection device according to claim 7, wherein the compliance (46) of the foil (30) is substantially constant over the predetermined range of the volume of cavity (28).

9. The liquid ejection device according to any of the previous claims, wherein the foil (30) is a polyimide foil (30).

10. The liquid ejection device according to any of the previous claims, wherein the liquid ejection device is a MEMS device formed in a photolithographic etching process.

11. The liquid ejection device according to according to any of the previous claims, wherein a substrate (20) comprising the cavity (28) has a thickness larger than a layer (16) comprising the pressure chamber (12) and the nozzles (10).

12. The liquid ejection device according to claim 11, wherein a substrate (20) comprising the cavity (28) has a thickness at least twice that of the layer (16) comprising the pressure chamber (12) and the nozzles (10).

13. The liquid ejection device according to claim 11 or 12, wherein the layer (16) is formed of two substrates stacked on one another, a first substrate comprising the pressure chamber (12) and a second substrate comprising the nozzle (10).

14. The liquid ejection device according to claim 11, 12 or 13, wherein the cavity (30) and an actuator cavity, wherein the actuator (22) is disposed, are formed in a single substrate (20).

15. The liquid ejection device according to any of the claims 11 to 14, wherein the substrates (16, 20) are formed of silicon.
